# EUROPÄISCHE PATENTSCHRIFT

(11) **EP 1 201 013 B1**
(45) Veröffentlichungstag und Bekanntmachung des Hinweises auf die Patenterteilung: **29.01.2003**
(21) Anmeldenummer: 00956096.2
(22) Anmeldetag: 26.07.2000
(51) Int. Cl.: H01S 5/40, H01S 5/343

(54) **MEHRFACH-HALBLEITERLASERSTRUKTUR MIT SCHMALER WELLENLÄNGENVERTEILUNG**
MULTI-SEMICONDUCTOR LASER STRUCTURE WITH NARROW WAVELENGTH DIVISION
STRUCTURE DE LASERS MULTIPLES A SEMI-CONDUCTEURS, A REPARTITION ETROITE DES LONGUEURS D'ONDE

(30) Priorität: 30.07.1999 DE 19935998
(43) Veröffentlichungstag der Anmeldung: 02.05.2002
(73) Patentinhaber: Osram Opto Semiconductors GmbH & Co. OHG, 93049 Regensburg (DE)
(72) Erfinder: HANKE, Christian, D-81737 München (DE)
(74) Vertreter: Epping Hermann & Fischer
(86) Internationale Anmeldenummer: DE0002449
(87) Internationale Veröffentlichungsnummer: WO01009997

(56) Entgegenhaltungen:
- FR-A- 2 761 537
- US-A- 5 212 706
- SKELDON M D: "A DESIGN APPROACH FOR A THERMALLY COMPENSATED INJECTION LASER STACK TRANSMITTER/RECEIVER" OPTICAL ENGINEERING,US,SOC. OF PHOTO-OPTICAL INSTRUMENTATION ENGINEERS. BELLINGHAM, Bd. 21, Nr. 6, 1. November 1982 (1982-11-01), Seiten 1046-1050, XP000712182 ISSN: 0091-3286
- GARCIA J CH ET AL: "EPITAXIALLY STACKED LASERS WITH ESAKI JUNCTIONS: A BIPOLAR CASCADE LASER" APPLIED PHYSICS LETTERS,US,AMERICAN INSTITUTE OF PHYSICS. NEW YORK, Bd. 71, Nr. 26, 29. Dezember 1997 (1997-12-29), Seiten 3752-3754, XP000735177 ISSN: 0003-6951 in der Anmeldung erwähnt

## Beschreibung

Die vorliegende Erfindung betrifft eine Mehrfach-Halbleiterlaserstruktur nach dem Oberbegriff des Patentanspruchs 1.

Im Zuge der Entwicklung von Halbleiterlasern hoher Ausgangsleistung wurden auch Halbleiterlaserstrukturen hergestellt, bei denen eine Mehrzahl von Halbleiterlasern flächig miteinander gekoppelt und in Reihe zwischen die Pole einer Spannungsquelle geschaltet werden. Die ersten Bauelemente dieser Art wurden dadurch hergestellt, daß mehrere Halbleiterlaser flächig miteinander verlötet wurden. Seit langem ist es jedoch bekannt (van der Ziel, et al., "Appl. Phys. Lett." 41, S. 500, 1982) mehrere GaAs-Doppelheterostrukturlaser dadurch miteinander zu verbinden, daß jeweils zwei vertikal benachbarte Laser-pn-Übergänge durch einen hochdotierten n⁺p⁺-Tunnelübergang miteinander verbunden werden. Dieser n⁺p⁺-Tunnelübergang besteht aus zwei dünnen n- bzw. p-dotierten Halbleiterschichten, wobei die n⁺-dotierte Schicht unmittelbar an das n-Gebiet des einen pn-Übergangs angrenzt und die p⁺-dotierte Schicht unmittelbar an das p-Gebiet des anderen pn-Übergangs angrenzt. Das Halbleitermaterial des Tunnelübergangs kann generell von dem Halbleitermaterial der angrenzenden pn-Übergänge verschieden oder mit diesem identisch sein. Wenn an die in Serie geschalteten pn-Übergänge über außen aufgebrachte Kontaktmetallisierungen eine Spannung in Vorwärtsrichtung angelegt wird, sind die n⁺p⁺-Übergänge in Rückwärtsrichtung gepolt. Aufgrund der hohen Dotierung bildet sich jedoch ein Tunnelübergang aus, der keinerlei Sperrwirkung besitzt. Vielmehr wird in dem n⁺p⁺-Tunnelübergang ein Löcherstrom vom p-Gebiet in einen Elektronenstrom im n-Gebiet umgewandelt. Dadurch wird ein hochleitfähiger, nahezu metallischer Kontaktübergang zwischen den vertikal benachbarten pn-Übergängen hergestellt. Erforderlich ist hierfür, daß die Dotierungskonzentrationen in den Schichten des n⁺p⁺-Tunnelübergangs im Bereich 10¹⁹cm-³ oder darüber liegen.

Die optischen Felder der übereinander liegenden Laserstrukturen können wahlweise miteinander verkoppelt oder entkoppelt sein. Dies wird durch die Dimensionierung von Schichtzusammensetzung und -dicken erreicht.

In der Publikation von Garcia, et al. in "Appl. Phys. Lett." 71, S. 3752, 1997 wird eine bei unterschiedlichen Wellenlängen emittierende InGaAs/AlGaAs-Laserstruktur beschrieben, bei welcher pn-Übergänge durch epitaktisches Aufwachsen übereinander gestapelt und durch einen niederohmigen n⁺p⁺-Tunnelübergang voneinander getrennt sind, bei welchem die n-Dotierung durch Kohlenstoff und die p-Dotierung durch Schwefel gebildet wird.

Aufgrund der endlichen Wärmeleitfähigkeit der einzelnen Schichten tritt jedoch das folgende Problem auf. In jedem der Laser-pn-Übergänge findet im Betrieb durch die Verlustleistung des elektrischen Stromes und durch nichtstrahlende Rekombinationsprozesse in den aktiven Zonen eine Erwärmung statt. Da jedoch die Halbleiterlaser vertikal übereinander gestapelt sind und mit dem gemeinsamen Substrat auf einer Wärmesenke montiert sind, fließt die solchermaßen produzierte Wärme von den einzelnen Halbleiterlasern unterschiedlich schnell zur Wärmesenke ab. Während der der Wärmesenke am nächsten liegende Halbleiterlaser seine überschüssige Wärme relativ schnell an die Wärmesenke abgeben kann, zeigt der Halbleiterlaser mit der größten Entfernung von der Wärmesenke die im Betrieb größte stationäre Erwärmung, da seine überschüssige Wärmemenge durch die gesamte Schichtstruktur bis zur Wärmesenke fließen muß. Insofern die aktiven Zonen der einzelnen Laser der Mehrfach-Halbleiterlaserstruktur gleichartig ausgeführt sind, werden diese Laser wegen der Temperaturabhängigkeit des Bandabstandes des verwendeten Halbleitermaterials jedoch Lichtstrahlung bei unterschiedlichen Wellenlängen emittieren. Dies ist für eine Reihe von Anwendungsfällen von Nachteil. Insbesondere das Pumpen von Festkörperlasern erfordert eine schmalbandige Emission des Halbleiterlasers, um die Absorptionsbande des Festkörperlasers effektiv zu nutzen.

Der vorliegenden Erfindung liegt demgemäß die Aufgabe zugrunde, eine Mehrfach-Halbleiterlaserstruktur vertikal übereinander gestapelter Laser-pn-Übergänge anzugeben, welche in der Lage ist, Lichtstrahlung mit einer schmalen Wellenlängenverteilung zu emittieren.

Diese Aufgabe wird durch die kennzeichnenden Merkmale des Patentanspruchs 1 gelöst.

Dementsprechend beschreibt die vorliegende Erfindung eine Mehrfach-Halbleiterlaserstruktur mit einer Mehrzahl von vertikal übereinander gestapelten Laser-pn-Übergängen, die jeweils eine aktive, lichtemittierende Zone aufweisen, und von denen jeweils vertikal benachbarte pn-Übergänge durch n⁺p⁺-Tunnelübergänge voneinander getrennt sind, die aus einer n⁺dotierten Schicht und einer p⁺-dotierten Schicht bestehen, wobei die n⁺-dotierte Schicht sich an das n-Gebiet des einen pn-Übergangs anschließt und die p⁺-dotierte Schicht sich an das p-Gebiet des anderen pn-Übergangs anschließt, und die n⁺- bzw. p⁺-Dotierungskonzentration derart gewählt ist, daß sich im Betrieb ein relativ niedriger elektrischer Widerstand des Tunnelübergangs ergibt, ferner
einer ersten Kontaktmetallisierung auf der p-Seite und einer zweiten Kontaktmetallisierung auf der n-Seite,
wobei die Materialzusammensetzung und/oder Dicke der aktiven lichtemittierenden Zonen der Laser-pn-Übergänge derart aufeinander abgestimmt sind, daß im Betrieb der Einfluß ihrer unterschiedlichen Betriebstemperaturen auf ihre Emissionswellenlänge kompensiert wird.

In einer ersten Ausführungsform der vorliegenden Erfindung werden die aktiven Zonen jweils durch die Trogschichten von Einfach- oder Mehrfach-Quantentrogstrukturen gebildet und die Dicken der Trogschichten verschiedener pn-Übergänge werden derart unterschiedlich gewählt, daß im Betrieb der Einfluß der unterschiedlichen Betriebstemperaturen der pn-Übergänge auf deren Emissionswellenlängen kompensiert wird. Bei einem praktischen Ausführungsbeispiel hiervon wird bei einem Halbleiterlaser, für den eine im Betrieb relativ hohe Arbeitstemperatur angenommen wird, eine relativ geringe Dicke der Quantentrogschicht gewählt, um der durch die Temperatur bewirkten Bandkantenabsenkung entgegenzuwirken.

Anstelle von Quantentrogstrukturen können auch Quantendrahtoder Quantenpunktstrukturen zum Einsatz kommen, wobei dann die Dicke des Quantendrahtes oder des Quantenpunktes entsprechend kompensatorisch gewählt wird.

In einer zweiten Ausführungsform der vorliegenden Erfindung werden die aktiven Zonen jeweils durch Volumenmaterialschichten gebildet, deren Materialzusammensetzungen verschiedener pn-Übergänge derart gewählt sind, daß im Betrieb der Einfluß der unterschiedlichen Betriebstemperaturen der pn-Übergänge auf deren Emissionswellenlängen kompensiert wird. Einer durch die Temperatur bewirkten Bandkantenabsenkung kann hier zum Beispiel durch einen erhöhten Al-Gehalt im AlGaAs-Volumenmaterial des pn-Übergangs entgegengewirkt werden.

Eine dritte Ausführungsform besteht in einer Kombination der vorgenannten ersten und zweiten Ausführungsformen. Hierbei werden sowohl die Dicken als auch die Materialzusammensetzungen der aktiven Zonen variiert, um den Temperatureinfluß auf die Bandkantenabsenkung zu kompensieren.

Im folgenden wird ein einziges Ausführungsbeispiel gemäß der ersten Ausführungsform der vorliegenden Erfindung anhand der Figuren näher erläutert. Es zeigen:
- Fig. 1: eine Mehrfach-Halbleiterlaserstruktur in einer perspektivischen Ansicht und einer auseinandergezogenen graphischen Darstellung der Schichtstruktur in Abhängigkeit von dem Al-Anteil der Schichten;
- Fig. 2: die in Fig. 1 dargestellte Mehrfach-Halbleiterlaserschichtstruktur wird im folgenden anhand des GaAs-Materialsystems erläutert.

Die vorliegende Erfindung ist jedoch nicht auf das GaAs-Materialsystem beschränkt und kann im Prinzip auf jedes andere Halbleitermaterialsystem angewandt werden.

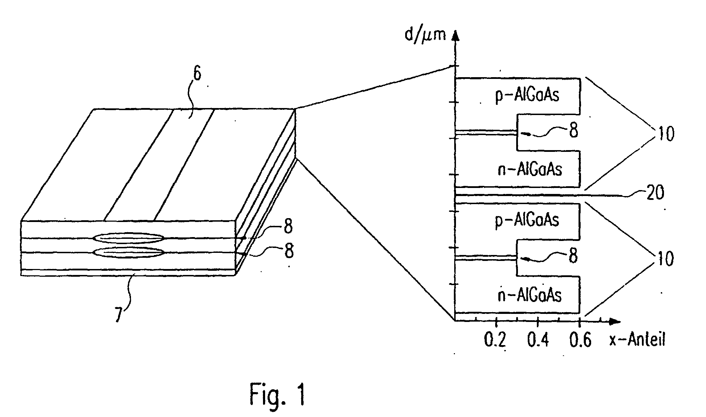

In der in der linken Hälfte der Fig. 1 perspektivisch dargestellten Mehrfach-Halbleiterlaserstruktur sind zwei pn-Übergänge 10 vertikal übereinander gestapelt und durch einen n⁺p⁺-Tunnelübergang 20 voneinander getrennt. Der Tunnelübergang 20 besteht aus zwei hochdotierten n⁺- bzw. p⁺-GaAs-Schichten, von denen die n⁺-Schicht an das n-Gebiet des einen benachbarten pn-Übergangs anschließt und die p⁺-Schicht an das p-Gebiet des anderen benachbarten pn-Übergangs anschließt. Jeder pn-Übergang weist eine aktive, lichtemittierende Zone 8 auf. Die Struktur enthält üblicherweise eine erste, obere Kontaktmetallisierung 6, die aus einem oder mehreren Streifen ausgebildet ist und an die p-Seite der Halbleiterlaserstruktur angeschlossen ist. Die gegenüberliegende Kontaktmetallisierung 7 ist an die n-Seite der Halbleiterlaserstruktur angeschlossen und wird üblicherweise ganzflächig auf das n-Substrat aufgebracht'.

In der rechten Hälfte der Fig. 1 ist ein Diagramm dargestellt, in welchem die Dicke d der Mehrfach-Halbleiterlaserschichtstruktur in um in Abhängigkeit von dem x-Anteil der einzelnen Ga₁₋ₓAlₓAs-Schichten dargestellt ist. Bei den einzelnen Laserstrukturen handelt es sich somit um Einzel-Quantentrogstrukturen, bei welchen die aktive Zone 8 durch eine dünne Schicht GaAs gebildet wird. Diese Schicht wird jeweils von zwei AlGaAs-Schichten mit einem Al-Gehalt von 0,3 umschlossen. An diese Schichten schließen sich AlGaAs-Schichten mit einem Al-Gehalt von 0,6 an. Zwischen diesen beiden äußeren Schichten wird die emittierte Lichtstrahlung aufgrund des stufenförmigen Verlaufs im Brechungsindex an der Grenzfläche der beiderseitigen AlGaAs-Schichten geführt, während die von außen injizierten Ladungsträger in der GaAs-Schicht eingefangen werden ("separate confinement"). Der die beiden pn-Übergänge verbindende Tunnelübergang 20 wird durch zwei hochdotierte n⁺- bzw. p⁺-dotierte GaAs-Schichten gebildet. Die Schichtdicke liegt vorzugsweise im Bereich 20 - 200 nm.

Im Betrieb steht die dargestellte Mehrfach-Halbleiterlaserstruktur auf einer Seite mit einer Wärmesenke in Verbindung. Daher stellt sich eine stationäre Temperaturverteilung ein, bei der die Temperatur mit zunehmendem Abstand von der Wärmesenke kontinuierlich zunimmt. Der von der Wärmesenke am weitesten entfernte Halbleiterlaser weist somit die im Betrieb höchste stationäre Arbeitstemperatur auf. Bei Halbleitermaterialien ist es jedoch bekannt, daß der Bandabstand mit zunehmender Temperatur abnimmt. Dies würde bedeuten, daß auch der Abstand der quantisierten Energieniveaus in den dünnen GaAs-Quantentrogschichten 8 abnehmen würde und demzufolge die Emissionswellenlänge zunehmen würde. Diesen Effekt gilt es zu kompensieren.

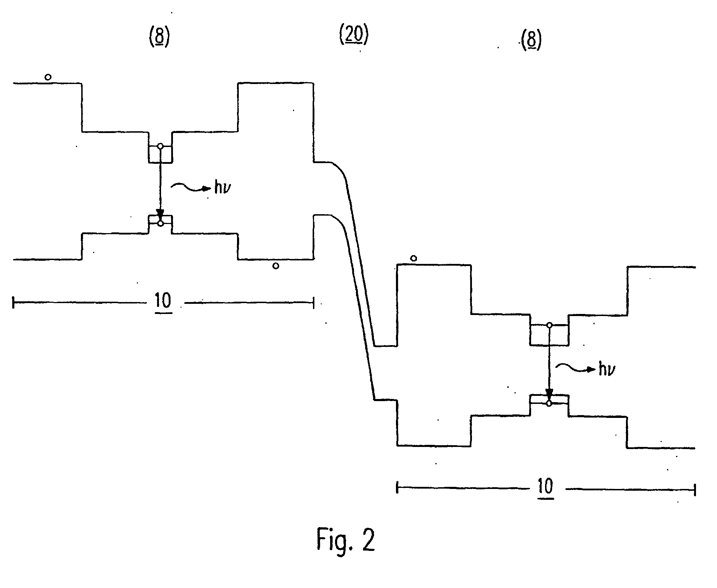

In Fig. 2 ist eine Energiebandstruktur der Mehrfach-Halbleiterlaserstruktur der Fig. 1 dargestellt. Innerhalb jedes pn-Übergangs 10 ist der stufenförmige Verlauf des Leitungs- und des Valenzbandes zu erkennen. Innerhalb der nominell undotierten, sehr dünnen GaAs-Quantentrogstruktur 8 wird im Leitungs- und Valenzband mindestens ein quantisiertes Energieniveau gebildet, so daß bei einer Strominjektion über den p-Streifenleiterkontakt Elektronen in die GaAs-Quantentrogschicht fließen und nach Eintritt der Besetzungsinversion ein Laserübergang zwischen den quantisierten Energieniveaus stattfinden kann. Die Kompensation der temperaturbedingten Verschiebung der Bandlücke wird dadurch herbeigeführt, daß für die beiden GaAs-Quantentrogschichten 8 unterschiedliche Dicken gewählt werden. Der in der rechten Bildhälfte der Fig. 2 dargestellte Halbleiterlaser befindet sich in unmittelbarer Nähe der Wärmesenke, so daß die in ihm produzierte Wärme relativ schnell abgeführt werden kann. Demgegenüber ist der in der linken Bildhälfte dargestellte Halbleiterlaser von der Wärmesenke in einem größeren Abstand positioniert, so daß er im.Betrieb eine höhere Arbeitstemperatur aufweist. Die dadurch bewirkte Verkleinerung der Bandlücke und somit der Energiedifferenz zwischen den quantisierten Energieniveaus wird dadurch kompensiert, daß für die entsprechende GaAs-Quantentrogschicht eine etwas geringere Dicke gewählt wird. Die Verkleinerung der Dicke bewirkt ein Hochsteigen der Energieniveaus in den Potentialtöpfen des Leitungs- und Valenzbandes der GaAs-Quantentrogschicht 8. Somit wird die durch den Temperatureinfluß bewirkte Absenkung der Energieniveaus kompensiert, so daß die aktiven Zonen beider Halbleiterlaser Lichtstrahlung mit der gleichen Wellenlänge emittieren.

In einer Modifikation dieser Ausführungsform kann jeder Halbleiterlaser auch aus einer Mehrfach-Quantentrogstruktur bestehen. Falls gewünscht und erforderlich kann auch innerhalb einer derartigen Mehrfach-Quantentrogstruktur eine variable Dicke der Quantentrogschichten eingestellt werden.

Das Ausmaß der erforderlichen Variation in den Dicken der unterschiedlichen Halbleiterlaser kann vor Herstellung der Mehrfach-Halbleiterlaserstruktur in einem relativ einfachen Wärmediffusionsmodell ermittelt werden. Dieses Modell sollte die stationären Betriebstemperaturen der Halbleiterlaser liefern, aus denen sich die temperaturabhängige Verkleinerung der Bandlücke unter Zuhilfenahme der einschlägigen Literatur ermitteln läßt. Sodann sollte ein relativ einfaches Potentialtopfmodell die zur Kompensation erforderliche Verringerung der Schichtdicke liefern.

Diese Vorgehensweise wird anhand des folgenden Beispiels verdeutlicht. Dem Beispiel ist ein GaAs-Halbleiterkörper mit der in Figur 1 dargestellten Struktur und einer Querschnittsfläche von 100 µm x 600 µm zugrundegelegt.

Die Dicke der Ga₁₋ₓAlₓAs-Schichten mit einem Al-Anteil von x=0,6 beträgt 1200 nm, die Dicke der Ga₁₋ₓAlₓAs-Schichten mit einem Al-Anteil von x=0,3 1000 nm und die Dicke der Tunnelschicht 400 nm. Die Zentralwellenlänge der emittierten Laserstrahlung liegt bei 800 nm. Die aktiven Zonen 8 sind als Quantentrog mit einer Dicke von 7 nm ausgeführt.

Es sei angenommen, daß die Temperaturen und die Emissionswellenlängen der aktiven Zonen 8 nicht zu stark voneinander abweichen, so daß eine linearisierte Berechnung als Näherung möglich ist. In diesem Fall genügt es, die Temperatürdifferenz zwischen den aktiven Zonen 8 zu ermitteln.

Betrachtet man die Schichtenfolge zwischen den aktiven Zonen 8 als Serie von thermischen Widerständen mit den in der nachfolgenden Tabelle angegenen Parametern, so ergibt sich zwischen den aktiven Zonen 8 als Summe der thermischen Einzelwiderstände ein Gesamtwiderstand von 6,1 K/W. Die aktiven Zonen 8 selbst können dabei aufgrund ihrer geringen Dicke vernachlässigt werden.

| Schichtart | Dicke | spezifischer thermischer Widerstand | thermischer Widerstand |
|---|---|---|---|
| aktive Zone | 7 nm | - | - |
| n-Ga₁₋ₓAlₓAs, x=0,3 | 1200 nm | 8,0 cmK/W | 1,6 K/W |
| n-Ga₁₋ₓAlₓAs, x=0,6 | 1000 nm | 8,5 cmK/W | 1,4 K/W |
| GaAs-Tunnelschicht | 400 nm | 2,0 cmK/W | 0,1 K/W |
| p-Ga₁₋ₓAlₓAs, x=0,3 | 1000 nm | 8,5 cmK/W | 1,4 K/W |
| p-Ga₁₋ₓAlₓAs, x=0,6 | 1200 nm | 8,0 cmK/W | 1,6 K/W |
| aktive Zone | 7 nm | - | - |

Bei einer typischen elektrischen Verlustleistung von 2,0 W in den aktiven Zonen 8 ergibt sich daraus eine Temperaturdifferenz von 12,2 K zwischen den aktiven Zonen 8. Dies führt bei einem Temperaturkoeffizienten der Emissionswellenlänge von 0.26 nm/K zu einer Wellenlängendifferenz von 3,2 nm zwischen den aktiven Zonen 8.

Für die zugrundegelegte Struktur des Halbleiterkörpers beträgt die differentielle Wellenlängenänderung in Abhängigkeit der Quantentrogdicke Δλ/Δd etwa 11,5 nm/nm.

Folglich läßt sich die Wellenlängendifferenz von 3,2 nm dadurch kompensieren, daß die Dicke der Quantentrogschicht mit der höheren Betriebstemperatur um 0,28 nm reduziert wird.

In dem Beispiel wurden typische, der einschlägigen Literatur entnommene Materialkonstanten des GaAs-Halbleitersystems verwendet.

Selbstverständlich können je nach Anwendungsfall auch andere, insbesondere experimentell gewonnene Daten herangezogen werden. Ebenso kann gegebenenfalls die Temperaturverteilung im Halbleiterkörper mittels weiterer Verfahren, beispielsweise mit Finite-Elemente-Methoden oder durch Lösung der Wärmeleitungsgleichung, ermittelt werden.

In der zweiten Ausführungsform der vorliegenden Erfindung wird die aktive Zone 8 durch einen aus Volumenmaterial gebildeten pn-Übergang gebildet. Dabei wird eine durch den Temperatureinfluß bewirkte Verkleinerung der Bandlücke dadurch kompensiert, daß in dem Ga₁₋ₓAlₓAs-Material des nominell undotierten Bereichs der aktiven Zone 8 der Al-Anteil x variiert wird. Für den von der Wärmesenke weiter weg entfernten Halbleiterlaser wird demzufolge ein größerer Wert x gewählt, wodurch die Bandlücke vergrößert wird und damit ihrer Verkleinerung durch die Temperaturerhöhung entgegengewirkt wird.

Für das oben angeführten Berechnungsbeispiel wird der Unterschied der Emissionswellenlängen von 3,2 nm durch eine Erhöhung des Al-Anteils x um 0,008 kompensiert.

Die dritte Ausführungsform der vorliegenden Erfindung wird beispielsweise dadurch realisiert, daß bei dem in den Figuren gezeigten Ausführungsbeispiel zusätzlich zur Variation der Dicke auch noch die Materialzusammensetzung der GaAs-Quantentrogschicht variiert wird. Durch die Materialzusammensetzung wird die Tiefe der Potentialtöpfe eingestellt. Somit kann der Temperatureinfluß auf die Bandlücke durch sowohl die Dicke der Trogschichten als auch die Tiefe ihrer Potentialtöpfe in geeigneter Wahl dieser Werte kompensiert werden.

Die Erfindung schafft somit einen Halbleiterlaser mit hoher Lichtausgangsleistung und schmaler Wellenlängenverteilung. Ein derartiger Halbleiterlaser ist insbesondere für das Pumpen von anderen Festkörperlasern wie Nd:YAG-Lasern hervorragend geeignet.

## Patentansprüche

1. Mehrfach-Halbleiterlaserstruktur mit
- einer Mehrzahl von vertikal übereinander gestapelten Laser-pn-Übergängen (10), die jeweils eine aktive, lichtemittierende Zone (8) aufweisen, und von denen
- jeweils vertikal benachbarte pn-Übergänge (10) durch n⁺p⁺-Tunnelübergänge (20) voneinander getrennt sind, die aus einer n⁺-dotierten Schicht und einer p⁺-dotierten Schicht bestehen, wobei die n⁺-dotierte Schicht sich an das n-Gebiet des einen pn-Übergangs (10) anschließt und die p⁺-dotierte Schicht sich an das p-Gebiet des anderen pn-Übergangs (10) anschließt, und die n⁺- bzw. p⁺-Dotierungskonzentration derart gewählt ist, daß sich im Betrieb ein relativ niedriger elektrischer Widerstand des Tunnelübergangs (20) ergibt,
- einer ersten Kontaktmetallisierung (6) auf der p-Seite,
- einer zweiten Kontaktmetallisierung (7) auf der n-Seite,
**dadurch gekennzeichnet, daß**
- die Materialzusammensetzung und/oder Dicke der aktiven, lichtemittierenden Zonen (8) der Laser-pn-Übergänge (10) derart aufeinander abgestimmt sind, daß im Betrieb der Einfluß ihrer unterschiedlichen Betriebstemperaturen auf ihre Emissionswellenlänge kompensiert wird.

2. Mehrfach-Halbleiterlaserstruktur nach Anspruch 1,
**dadurch gekennzeichnet, daß**
- die aktiven Zonen (8) jeweils durch die Trogschichten von Einfach- oder Mehrfach-Quantentrogstrukturen oder durch Einfach- oder Mehrfach-Quantentrogdraht- oder Quantenpunktstrukturen gebildet sind, und
- die Dicken der Trogschichten oder der Quantendraht- oder Quantenpunktstrukturen verschiedener pn-Übergänge derart unterschiedlich gewählt sind, daß im Betrieb der Einfluß der unterschiedlichen Betriebstemperaturen der pn-Übergänge auf deren Emissionswellenlängen kompensiert wird.

3. Mehrfach-Halbleiterlaserstruktur nach Anspruch 2,
**dadurch gekennzeichnet, daß**
- die Laserstruktur auf einer Wärmesenke montiert ist, und
- die Dicke der Trogschichten mit zunehmendem Abstand des jeweiligen pn-Übergangs (10) von der Wärmesenke abnimmt..

4. Mehrfach-Halbleiterlaserstruktur nach einem der vorhergehenden Ansprüche,
**dadurch gekennzeichnet, daß**
- die Dicke der Trogschichten und deren Materialzusammensetzungen variiert werden.

5. Mehrfach-Halbleiterlaserstruktur nach Anspruch 1,
**dadurch gekennzeichnet, daß**
- die aktiven Zonen (8) jeweils durch Volumenmaterialschichten gebildet sind, deren Materialzusammensetzungen verschiedener pn-Übergänge (10) derart gewählt sind,
- daß im Betrieb der Einfluß der unterschiedlichen Betriebstemperaturen der pn-Übergänge (10) auf deren Emissionswellenlängen kompensiert wird.

6. Mehrfach-Halbleiterlaserstruktur nach Anspruch 5,
**dadurch gekennzeichnet, daß**
- die Laserstruktur auf einer Wärmesenke montiert ist, und
- die Materialzusammensetzung der Volumenmaterialschichten mit zunehmendem Abstand von der Wärmesenke derart gewählt sind, daß sich eine Vergrößerung der Bandlücke des Materials ergibt.

## Claims

1. Multiple semiconductor laser structure with
- a plurality of laser pn junctions (10) stacked vertically one on top of the other which have in each case an active, light-emitting zone (8), and of which
- respectively vertically neighbouring pn junctions (10) are separated from one another by n⁺p⁺ tunnel junctions (20), which comprise an n⁺-doped layer and a p⁺-doped layer, the n⁺-doped layer adjoining the n region of the one pn junction (10) and the p⁺-doped layer adjoining the p region of the other pn junction (10), and the n⁺- and p⁺-doping concentration being chosen such that a relatively low electrical resistance of the tunnel junction (20) is obtained during operation,
- a first contact metallization (6) on the p side,
- a second contact metallization (7) on the n side,
**characterized in that**
- the material composition and/or thickness of the active, light-emitting zones (8) of the laser pn junctions are made to match one another in such a way that the influence of their different operating temperatures on their emission wavelength is compensated during operation.

2. Multiple semiconductor laser structure according to Claim 1, **characterized in that**
- the active zones (8) are respectively formed by the well layers of single or multiple quantum well structures or by single or multiple quantum wire structures or quantum dot structures, and
- the thicknesses of the well layers or of the quantum wire structures or quantum dot structures of different pn junctions are chosen differently such that the influence of the different operating temperatures of the pn junctions on their emission wavelengths is compensated during operation.

3. Multiple semiconductor laser structure according to Claim 2, **characterized in that**
- the laser structure is mounted on a heat sink, and
- the thickness of the well layers decreases with increasing distance of the respective pn junction (10) from the heat sink.

4. Multiple semiconductor laser structure according to one of the preceding claims, **characterized in that**
- the thickness of the well layers and their material compositions are varied.

5. Multiple semiconductor laser structure according to Claim 1, **characterized in that**
- the active zones (8) are respectively formed by bulk material layers, the material compositions of different pn junctions (10) of which are chosen such that
- the influence of the different operating temperatures of the pn junctions (10) on their emission wavelengths is compensated during operation.

6. Multiple semiconductor laser structure according to Claim 5, **characterized in that**
- the laser structure is mounted on a heat sink, and
- the material composition of the bulk material layers with increasing distance from the heat sink is chosen such that an increase in the band gap of the material is obtained.

## Revendications

1. Structure de lasers multiples à semi-conducteurs avec
- plusieurs jonctions pn lasers (10) qui sont empilées verticalement les unes sur les autres et qui comportent chacune une zone active (8) émettant de la lumière, et dont
- les jonctions pn (10) verticalement adjacentes respectives sont séparées les unes des autres par des jonctions tunnels n⁺p⁺ (20) qui sont constituées d'une couche dopée n⁺ et d'une couche dopée p⁺, la couche dopée n⁺ faisant suite à la région n d'une jonction pn (10) et la couche dopée p⁺ faisant suite à la région p de l'autre jonction pn (10) et la concentration de dopage n⁺ ou p⁺ étant choisie de manière à avoir lors du fonctionnement une résistance électrique relativement petite de la jonction tunnel (20),
- une première métallisation de contact (6) du côté p
- une deuxième métallisation de contact (7) du côté n,
**caractérisée par le fait que**
- la composition de matériau et/ou l'épaisseur des zones actives (8), émettant de la lumière, des jonctions pn lasers (10) sont accordées les unes aux autres de telle sorte que, lors du fonctionnement, l'influence de leurs différentes températures de fonctionnement sur leur longueur d'onde d'émission est compensée.

2. Structure de lasers multiples à semi-conducteurs selon la revendication 1,
**caractérisée par le fait que**
- les zones actives (8) sont formées à chaque fois par les couches en puits de structures en puits de quanta simples ou multiples ou par des structures en fils ou en points de quanta simples ou multiples, et
- les épaisseurs des couches en puits ou des structures en fils ou en points de quanta de différentes jonctions pn sont choisies différentes de telle sorte que, lors du fonctionnement, l'influence des différentes températures de fonctionnement des jonctions pn sur leurs longueurs d'onde d'émission est compensée.

3. Structure de lasers multiples à semi-conducteurs selon la revendication 2,
**caractérisée par le fait que**
- la structure laser est montée sur un puits de chaleur, et
- l'épaisseur des couches en puits diminue lorsque la distance de la jonction pn respective (10) au puits de chaleur augmente.

4. Structure de lasers multiples à semi-conducteurs selon l'une des revendications précédentes,
**caractérisée par le fait que**
- l'épaisseur des couches en puits et les compositions de leurs matériaux sont modifiées.

5. Structure de lasers multiples à semi-conducteurs selon la revendication 1,
**caractérisée par le fait que**
- les zones actives (8) sont formées par des couches de matériau en volume dont les compositions de matériau de différentes jonctions pn (10) sont choisies de telle sorte
- que, lors du fonctionnement, l'influence des différentes températures de fonctionnement des jonctions pn (10) sur leurs longueurs d'onde d'émission est compensée.

6. Structure de lasers multiples à semi-conducteurs selon la revendication 5,
**caractérisée par le fait que**
- la structure laser est montée sur un puits de chaleur, et
- la composition de matériau des couches de matériau en volume lorsque la distance au puits de chaleur augmente est choisie de manière à avoir une augmentation de l'écart énergétique du matériau.
